(19) **Europäisches Patentamt / European Patent Office / Office européen des brevets**

(11) **EP 1 466 199 B1**

(12) **EUROPEAN PATENT SPECIFICATION**

(45) Date of publication and mention
of the grant of the patent:
**30.05.2007 Bulletin 2007/22**

(21) Application number: **03708843.2**

(22) Date of filing: **16.01.2003**

(51) Int Cl.:
*G02B 6/12* (2006.01)

(86) International application number:
**PCT/US2003/001445**

(87) International publication number:
**WO 2003/062908 (31.07.2003 Gazette 2003/31)**

(54) **THREE-DIMENSIONAL PHOTONIC CRYSTAL WAVEGUIDE STRUCTURE**

WELLENLEITERSTRUKTUR BASIEREND AUF EINEM DREIDIMENSIONALEN PHOTONISCHEN KRISTALL

STRUCTURE DE GUIDE D'ONDES

(84) Designated Contracting States:
**AT BE BG CH CY CZ DE DK EE ES FI FR GB GR HU IE IT LI LU MC NL PT SE SI SK TR**

(30) Priority: **17.01.2002 US 52952**
**17.01.2002 US 53003**

(43) Date of publication of application:
**13.10.2004 Bulletin 2004/42**

(73) Proprietor: **MICRON TECHNOLOGY, INC.**
**Boise,**
**Idaho 83716-9632 (US)**

(72) Inventors:
• **GEUSIC, Joseph, E.**
**Berkeley Heights, NJ 07922 (US)**
• **FORBES, Leonard**
**Corvallis, OR 97330 (US)**

(74) Representative: **Collins, John David**
**Marks & Clerk**
**90 Long Acre**
**London WC2E 9RA (GB)**

(56) References cited:
**EP-A- 1 030 196        EP-A- 1 085 352**
**WO-A-98/35248          US-A- 5 471 180**
**US-A- 5 526 449**

• **BIRNER A ET AL: "SILICON-BASED PHOTONIC CRYSTALS" , ADVANCED MATERIALS, VCH VERLAGSGESELLSCHAFT, WEINHEIM, DE, VOL. 13, NR. 6, PAGE(S) 377-388 XP001039026 ISSN: 0935-9648 page 383 -page 388**
• **PATENT ABSTRACTS OF JAPAN vol. 2000, no. 21, 3 August 2001 (2001-08-03) & JP 2001 093887 A (TOSHIBA CORP), 6 April 2001 (2001-04-06)**
• **MIZUSHIMA I ET AL: "EMPTY-SPACE-IN-SILICON TECHNIQUE FOR FABRICATING A SILICON-ON-NOTHING STRUCTURE" , APPLIED PHYSICS LETTERS, AMERICAN INSTITUTE OF PHYSICS. NEW YORK, US, VOL. 77, NR. 20, PAGE(S) 3290-3292 XP000970310 ISSN: 0003-6951 the whole document**

## Description

The present invention pertains to waveguides, and in particular to waveguide structures and methods employing photonic crystals.

The wave nature of electrons and the periodic lattice of atoms give rise to allowed energy bands and forbidden energy gaps for electrons in a solid. The forbidden gaps arise from the destructive interference of electrons for certain wavelengths and directions. If a forbidden gap exists for all possible directions, it is referred to as a complete bandgap. A semiconductor has a complete bandgap between the valence and conduction bands.

The optical analogy is the photonic crystal, where a periodic lattice of contrasting dielectric structures (i.e., different indices of refraction) provides the periodic potential for light that atoms do for electrons. Photonic crystals can be thought of as extensions of diffraction gratings (i.e., a one-dimensional photonic crystal) or naturally occurring crystals used in X-ray crystallography. Light interacting with a diffraction grating or X-ray crystal interacts with the periodic structure and is redistributed into "allowed" and precluded from "forbidden" directions. The forbidden directions are the "photonic bandgaps" of the structure.

Photonic crystals can be designed with photonic bandgaps that prevent light of a certain wavelength and direction from propagating within the photonic crystal. If the photonic crystal does not allow light to propagate within a wavelength range for all polarizations and directions, it is said to have a "complete photonic bandgap." A necessary condition for a complete photonic bandgap is that the contrasting dielectric lattice be periodic in three dimensions (3D).

Research of photonic crystals and their behavior was prompted by the article by Yablonovitch, entitled "Inhibited spontaneous emission in solid-state physics and electronics," in *Phys. Rev. Lett.* 58, No. 20, 2059-2062 (1987). Based on theoretical considerations, a number of new optical devices, from better lasers to extremely miniaturized light switches and guides, have been suggested by workers in this relatively new field.

While photonic crystals offer a great deal of promise in fabricating new devices, fabricating such crystals with predetermined structures is daunting. The article by Yablonovitch et al., entitled "Photonic band structure: the face-centered-cubic case employing nonspherical atoms," in *Phys. Rev. Lett.* 67, No. 17, 2295-2298 (1991), describes the formation of the first artificial 3D photonic crystal by drilling an array of intersecting millimeter size holes in a dielectric material. This photonic crystal has a bandgap in the microwave range of the spectrum and is of limited practical interest.

Since the early pioneering work by Yablonovitch, a great deal of research has been devoted to the fabrication and study of photonic crystals in the infrared and visible. The article by Birner et al., entitled "Silicon-based photonic crystals," in *Adv. Mater.* 13, No. 6, March 16, 2001, describes fabricating two-dimensional (2D) and 3D photonic crystals. 2D photonic crystals have periodicity in two dimensions and are uniform in the third dimension and are much easier to fabricate than 3D photonic crystals. Although a 2D photonic crystal can not have a complete bandgap in the strictest sense, it can have a forbidden gap that exists for all directions and polarizations of propagation precisely confined to the plane of periodicity. In this more limited sense, the forbidden gap is referred to as a "complete 2D bandgap."

One application for a 3D photonic crystal having a complete bandgap is to guide light. This can be accomplished by carving a path into such a photonic crystal to serve as an air-filled waveguide. Light that propagates in the air-filled waveguide at a frequency within the complete bandgap will be totally reflected by the photonic crystal and be totally confined to and directed along the waveguide. It should confine light around tight bends much better than conventional waveguides (e.g., optical fibers), where the guiding depends on the limited angular range of total internal reflection at the interface between the higher index core and the lower index cladding.

Much work has been done in the area of 2D photonic crystals. For example, the formation of a two-dimensional array of very small cylindrical holes with a diameter of about 1 micron fabricated in a silicon substrate by electrochemical etching is describe in the article by Birner et al., entitled "Microporous silicon: A two-dimensional photonic bandgap material suitable for the near-infrared spectral range," *Phys. Status Solids,* A 165, 111 (1998). As described in the article by Johnson et al., entitled "Guided modes in photonic crystal slabs," Phys. Rev. B, 60 5751 (1999), this technique has been further developed to form a triangular lattice of 0.36 micron holes on a 0.5 micron pitch to produce a 2D photonic crystal with a "complete 2D bandgap" at a free space wavelength of 1.25 micron.

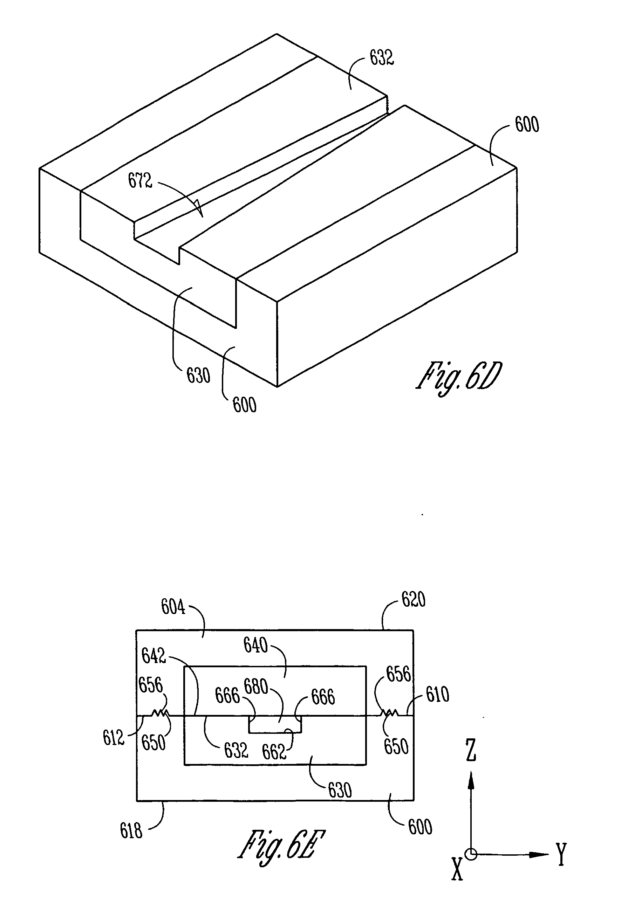

The article by Loncar et al., entitled "Waveguiding in planar photonic crystals," *Appl. Phys. Lett.,* 77, No. 13, 25 September 2000, pp. 2813-2815, describes the fabrication of a 2D photonic crystal circuits designed and fabricated in silicon on silicon dioxide. The circuits include a planar waveguide that guides at 1.5 micron and utilizes a 2D photonic crystal consisting of a triangular lattice of cylindrical holes formed by chemically assisted ion-beam etching in silicon, as shown in Figure 2 of the article. A silicon slab waveguide is formed by omitting one row of cylindrical holes from the 2D photonic crystal. The top and bottom surfaces of the slab waveguide and the photonic crystal are in contact with air. The structure utilizes 2D lateral confinement by the 2D photonic crystal, while confinement in the vertical (i.e., third dimension) is from conventional total internal reflection at the top and bottom Si/air interface. The article discusses propagation in straight sections and around 60° and 90° bends.

While 2D photonic crystal waveguides are useful for certain applications such as planar circuits and distributed feedback (DFB) lasers, there are a host of other applications (e.g., the formation of ultra-small optical and electro-optical integrated circuits and devices) that call for 3D photonic crystal waveguides. To date, however, readily forming 3D photonic crystals waveguides has proven difficult. This is particularly true where the desired bandgap wavelength is at the optical or infrared, since the dimensions of the lattice must be a fraction of the bandgap wavelength.

While some techniques have been developed for fabricating 3D photonic crystals, they involve extreme process conditions, such as forming individual dielectric layers and then stacking and bonding the layers to build the crystal. The formation of 3D waveguides in such crystals adds yet another level of complexity.

Whether a particular 3D photonic crystal has a complete or incomplete photonic bandgap depends on the particular lattice type and its parameters (e.g., the size, shape and spacing of the voids). Fortunately, the bandgap properties of a photonic crystal formed from a given lattice type (e.g., diamond) can be calculated. One technique for determining band gap properties of a 3D photonic crystal based on the lattice parameters is presented in the article by Ho et al., entitled "Existence of a photonic gap in periodic dielectric structures," *Phys. Rev. Lett.,* 65, No. 25, 3152-3155 (1990).

The Ho article shows that certain crystals lattices (e.g., diamond) can form 3D photonic crystals having either a complete or incomplete bandgap, depending on the above-mentioned lattice parameters.

Accordingly, there is a need for an improved method of forming waveguides and waveguide-based devices from 3D photonic bandgap crystals. The present invention provides method of forming a three-dimensional photonic crystal waveguide structure, comprising: forming a first three-dimensional photonic crystal region having a complete photonic bandgap; forming a second three-dimensional photonic crystal region having the complete photonic bandgap, wherein the first and second three-dimensional photonic crystal regions are substantially identical; forming a channel in the first and/or second three-dimensional photonic crystal region; and interfacing the first and second three-dimensional photonic crystal regions to form a single three-dimensional photonic crystal region so that said channel forms a three-dimensional waveguide surrounded by the first and second three-dimensional photonic crystal regions and sized to receive and guide radiation of a wavelength corresponding to the complete photonic bandgap.

Each of the first and second 3D photonic crystal regions includes a first periodic arrays of unit cells formed from first voids with an incomplete photonic bandgap, the first voids being connected by imaginary bonds. Each of the first and second 3D photonic crystal regions also includes a second periodic arrays of second voids in which each second void is arranged along one of the imaginary bonds to modify each of the unit cells to form a 3D photonic crystal region with a complete photonic bandgap.

The method of forming the waveguide structure includes forming a first 3D photonic crystal region and a second 3D photonic crystal region. A channel is formed in the first 3D photonic crystal region. The first and second 3D photonic crystal regions are interfaced to form a 3D waveguide defined by the channel and a portion of the second 3D photonic crystal region covering the channel.

These and other embodiments, aspects, advantages, and features of the present invention will be set forth in part in the description which follows, and in part will become apparent to those skilled in the art by reference to the following description of the invention and referenced drawings or by practice of the invention. The aspects, advantages, and features of the invention are realized and attained by means of the instrumentalities, procedures, and combinations particularly pointed out in the appended claims.

Figure 1 illustrates fourteen representative unit cells with voids as "atoms," as examples of unit cells that can be as a basis for forming the complete bandgap . 3D photonic crystal waveguide structure of the present invention;

Figure 2A is a plot taken from the article by Ho et al. that graphs the gap/mid-gap ratio as a function of the filling ratio for a diamond crystal structure comprising air spheres formed in a solid dielectric substrate;

Figure 2B is a plot adapted from the article by Ho et al. that plots the gap/mid-gap ratio as a function of the refractive index contrast (ratio) between air spheres and the refractive index of the substrate, for a diamond crystal structure comprising air spheres wherein the filling ratio is 81 %;

Figure 3A is an isometric view of a photonic crystal made up an array of diamond unit cells formed in a substrate;

Figure 3B illustrates one of the diamond unit cells used to form the photonic crystal of Figure 3A, wherein each diamond unit cell is formed from spherical void "atoms" created in solid substrate, where the "atoms" are linked by imaginary tetrahedral "bonds";

Figure 3C is a diagram representing the spherical void positions in the diamond unit cell of Figure 3B as projected on a cube face, with the fractions denoting the height above the base in lattice constant $(a_0)$ units;

Figure 4 is a top-down perspective view of a substrate having formed therein cylindrical holes of a select length L, radius R and spacing S prior to forming spherical voids via surface transformation;

Figure 5A is an isometric view of a photonic crystal made up an array of modified diamond unit cells formed in a substrate;

Figure 5B illustrates a modified diamond unit cell formed by modifying the diamond unit cell of Figure 3A by forming additional spherical voids halfway between the existing spherical voids along the tetrahedral bonds;

Figure 5C is the same plot as Figure 3C, but for the modified diamond unit cell of Figure 5A;

Figure 6A is a cross-sectional view of first and second substrates each having formed therein substantially identical 3D photonic crystal regions;

FIG 6B is a cross-sectional view of the first substrate of Figure 6A, with a channel formed in the surface of the 3D photonic crystal region;

Figure 6C is a top-down perspective view of the first substrate, with a channel having a bend formed in the 3D photonic crystal region;

Figure 6D is a top-down perspective view of the first substrate with a tapered channel formed in the 3D photonic crystal region;

Figure 6E is a cross-sectional view of the and second substrates aligned and bonded to one another to form the channel waveguide;

Figure 6F is a cross-sectional diagram similar to Figure 6B, but wherein the second 3D photonic crystal region also has a channel;

Figure 6G is a cross-sectional view of the bonded substrates of Figure 6E, with the bottom surface of the second (top) substrate polished down to at or just above the 3D photonic crystal region of the second substrate; and

Figure 7 is a cross-sectional view of a 3D photonic crystal waveguide optical system that includes the 3D photonic crystal waveguide of Figure 6E.

In the Figures, the first digit of the reference number corresponds to the Figure number. Accordingly, like elements in different Figures have reference numbers that differ only in the first digit that identifies the Figure number.

In the following detailed description of the embodiments of the invention, reference is made to the accompanying drawings that form a part hereof and in which is shown by way of illustration specific embodiments in which the invention may be practiced. These embodiments are described in sufficient detail to enable those skilled in the art to practice the invention, and it is to be understood that other embodiments may be utilized and that changes may be made without departing from the scope of the present invention. The following detailed description is, therefore, not to be taken in a limiting sense, and the scope of the present invention is defined only by the appended claims.

The term "substrate" as used in the following description includes any material, structure or combination of material/structure for which its optical, electronic, and acoustic properties, among others, can be modified by the formation or rearrangement of photonic energy bands in such material, structure, or combination thereof. Thus, the term "substrate" is understood as including, for example, linear and non-linear optical materials, metals, semiconductors and insulators/dielectrics, acoustic materials, magnetic materials, ferroelectric materials, piezoelectric materials, and superconducting materials, among others. In addition, the term "substrate" is understood as including substrates formed on silicon, silicon-on-insulator, doped and undoped semiconductors, epitaxial layers of silicon supported by a base semiconductor foundation, and other semiconductor structures. Further, when reference is made to a semiconductor "substrate" in the following description, previous process steps may have been utilized to form regions or junctions in the base semiconductor structure or foundation.

**Forming a 3D photonic crystal with complete bandgap**

The present embodiment involves the formation of a complete bandgap 3D photonic crystal to create a fully confined 3D photonic bandgap waveguide structure. The complete bandgap 3D photonic crystal used to fabricate the waveguide structure is formed from a periodic array of voids created in a solid substrate. A preferred technique for creating such voids is called "surface transformation of empty spaces" (or "surface transformation," for short), which is described in detail in U:S. Patent Application Serial No. 09/861,770, filed on May 22, 2001, and entitled "Method of forming three-dimensional photonic band structures in solid materials,"

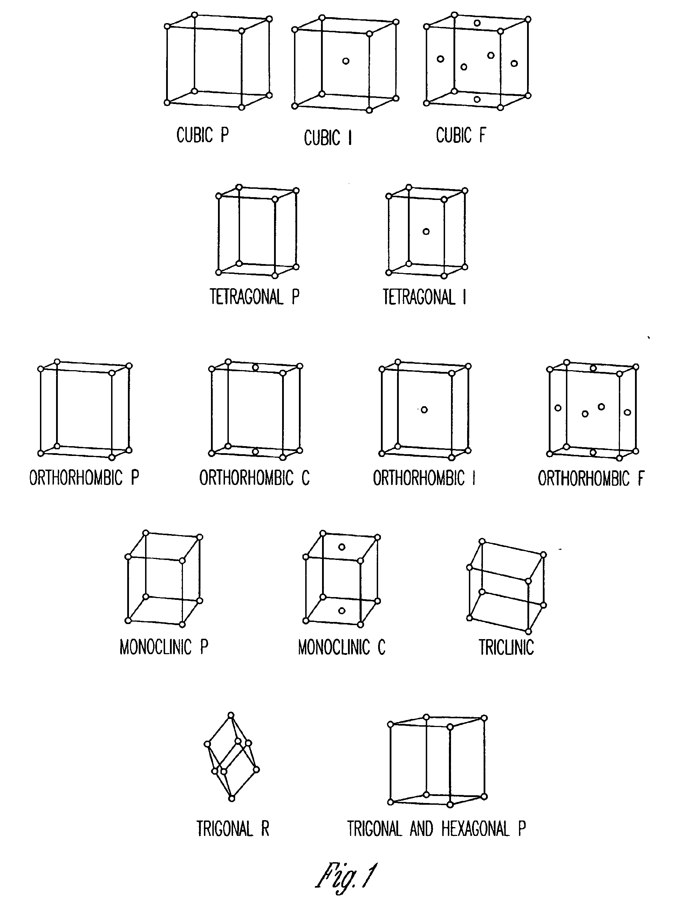

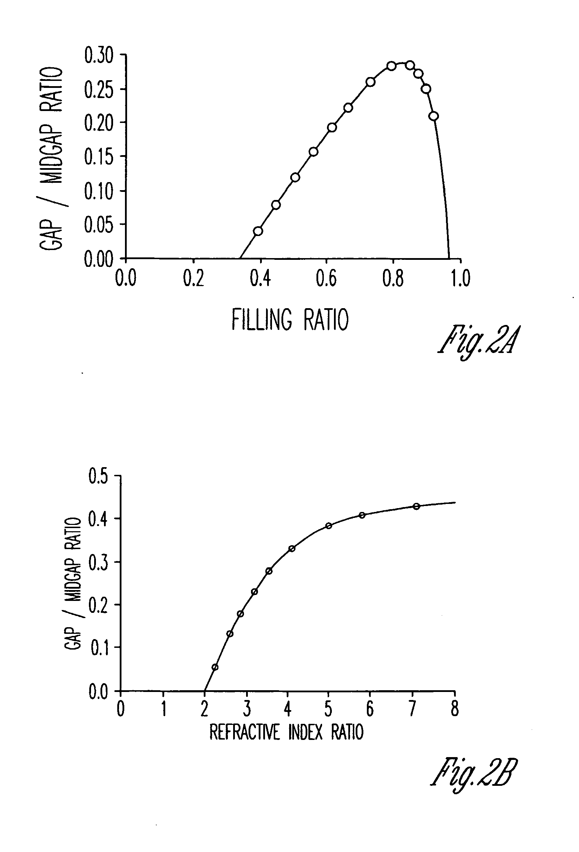

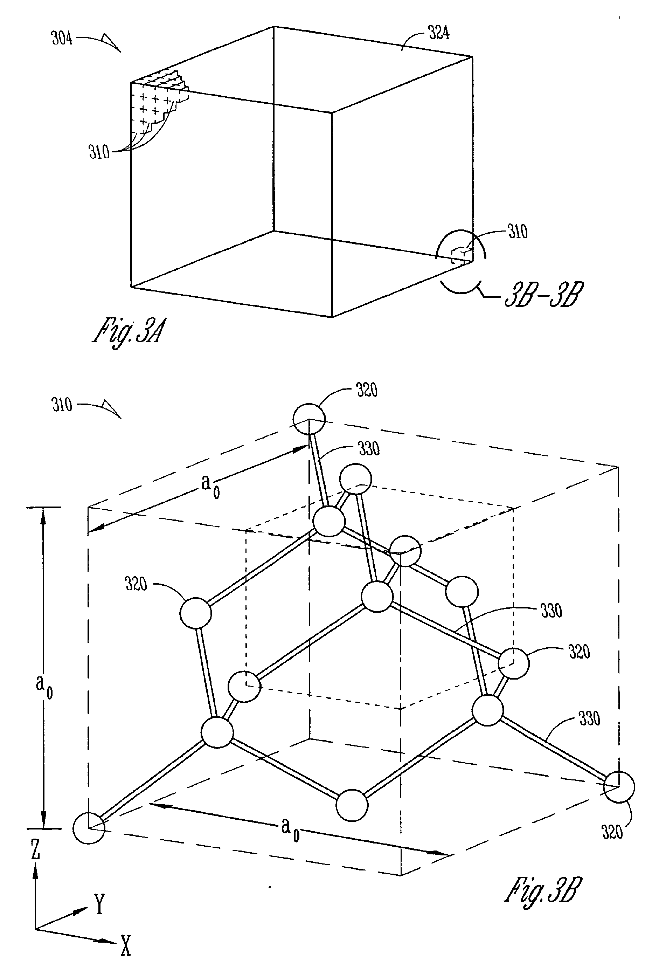

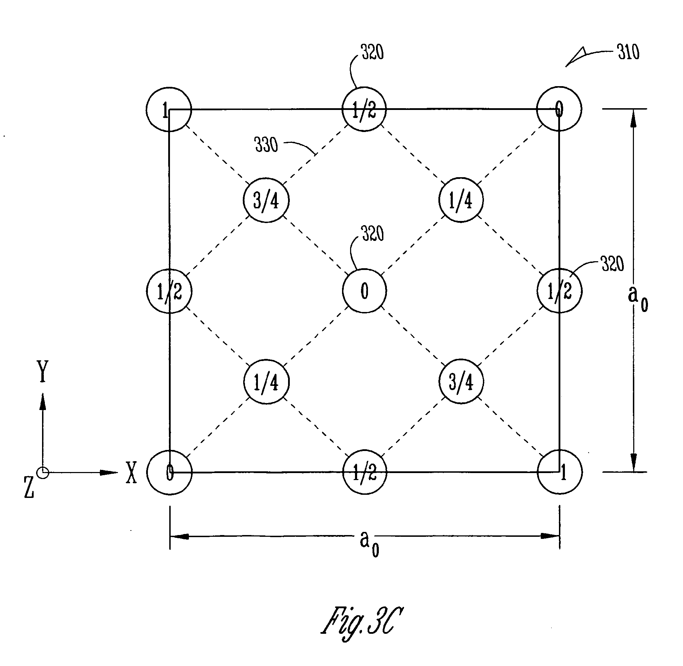

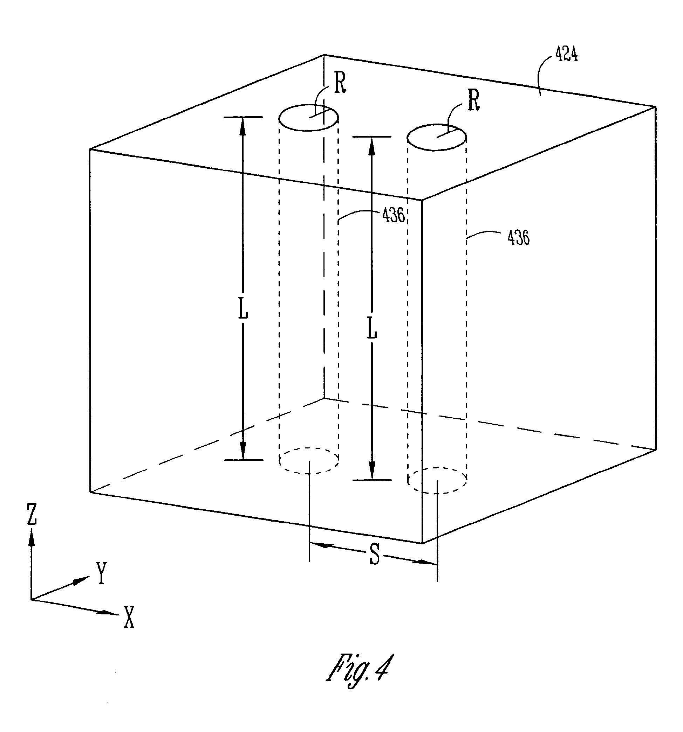

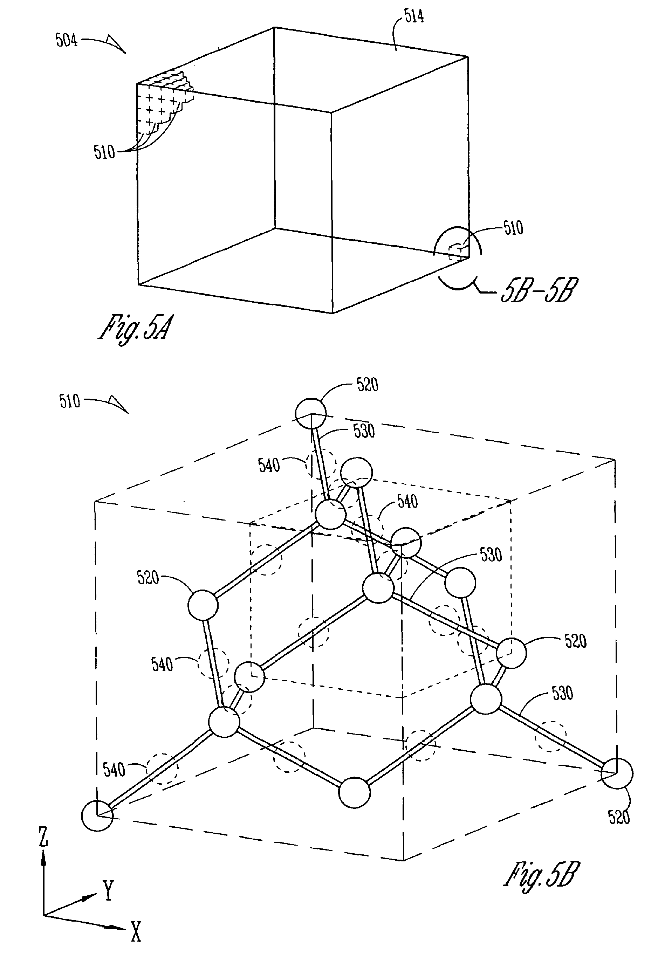

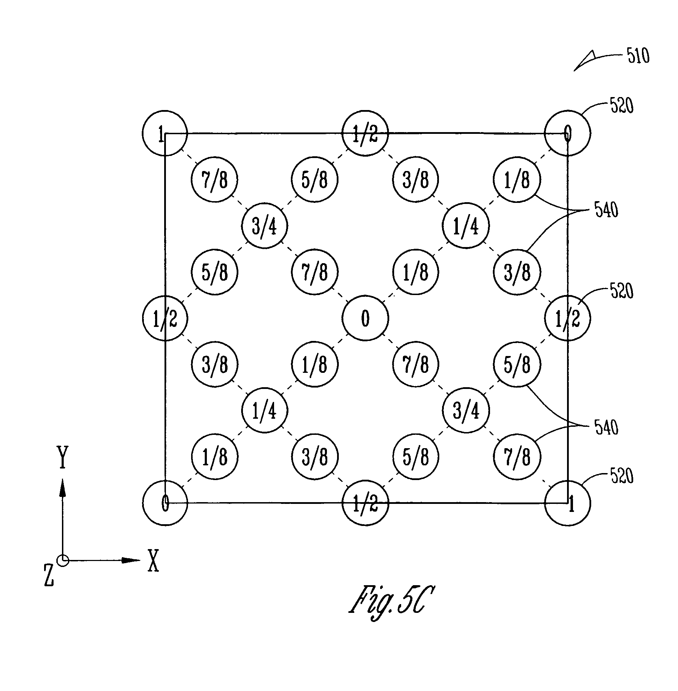

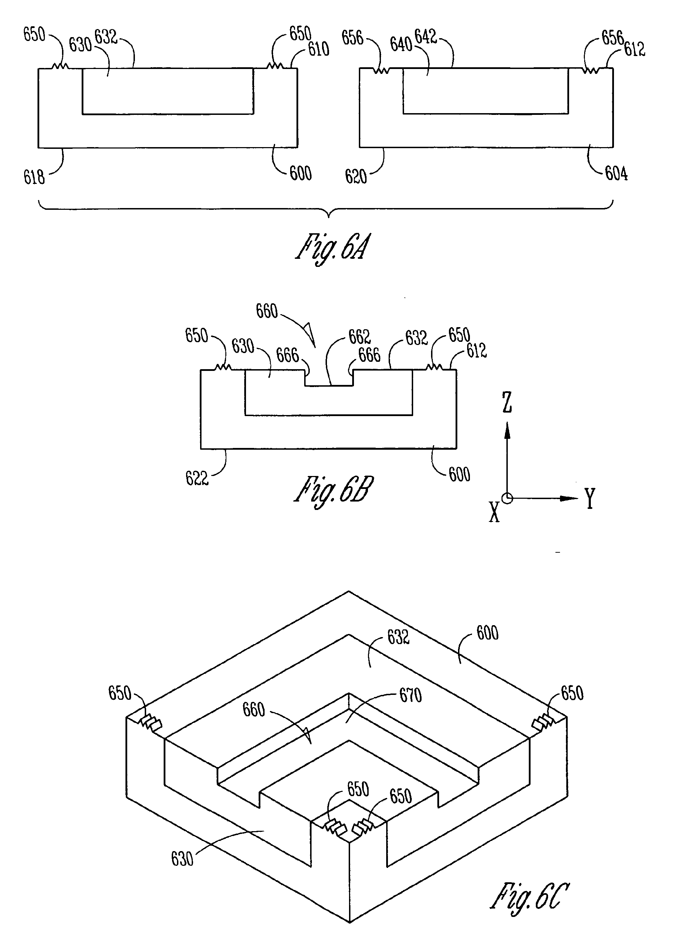

Using the surface transformation technique, a 3D photonic crystal of any lattice symmetry can be fabricated. Any one of a number of space group symmetries can be formed in a substrate of virtually any solid material by surface transformation, to control its optical and electromagnetic properties. The space group symmetries include a plurality of voids formed in the substrate by drilling holes to a predefined depth and at a predefined lattice position, and then heating the material at a temperature close to the melting point of the substrate material, to spontaneously form void patterns at the desired lattice position. The voids may have various geometries (e.g., spherical, cylindrical, piste-like, etc.) and may be formed at different periodicities and in a variety of space group symmetries using, for example, the representative unit cells of Figure 1, which are described by C. Kittel in *Introduction to Solid State Physics,* J. Wiley & Sons, 3d Ed., (1966).

As a general rule, the wavelength of the photonic bandgap is about twice the period (i.e., lattice constant $a_0$) of the photonic crystal. Thus, to achieve a bandgap for a desired wavelength (e.g., x-ray, ultraviolet, visible, infrared, microwave, etc.), the lattice constant $a_0$ should be a fraction of the desired wavelength. The wavelength and width of the photonic bandgap also depend on the filling ratio, which is the ratio of the volume of the voids in the unit cell to the total volume of the unit cell.

By properly selecting the lattice constant $a_0$ and the "atom" (i.e., void) shape and size, a variety of 3D photonic crystals and thus 3D photonic crystal waveguide structures can be produced for the wavelength region of interest. The lower bound of the photonic bandgap wavelength is determined mainly by the smallest lattice constant $a_0$ and voids that can be formed in the particular substrate.

## Waveguide structure with modified 3D photonic crystal

As mentioned above, the 3D photonic crystal waveguide structure of the present embodiment requires the formation of a complete bandgap 3D photonic crystal. However, certain 3D photonic crystals formed with certain space group symmetries and voids of a given size and/or shape may not provide the necessary complete photonic bandgap at one filling ratio but may do so at another. Thus, a waveguide structure can be formed using a 3D photonic crystal modified to form a complete bandgap.

Ho et al., in their article entitled "Existence of a photonic gap in periodic dielectric structures," *Phys. Rev. Lett.,* 65, No. 25, 17 Dec. 1990, pp. 3152-3155, have calculated the photonic band structure of the diamond lattice for air spheres (i.e., spherical voids) of various sizes in a dielectric background. Ho et al. have identified the conditions under which a complete bandgap exists for a diamond lattice of spherical voids.

Figure 2A is adapted from the article by Ho (Figure 3(a) therein), and plots the "gap/mid-gap ratio" versus the filling ratio for air spheres formed in a solid substrate. The gap/mid-gap ratio is the ratio of the size of the calculated bandgap (in units of frequency) of the diamond crystal normalized to the mid-gap frequency. From Figure 2, it can be seen that a filling ratio of about 0.35 or greater is required to achieve a complete bandgap. Further, the gap/mid-gap ratio grows until a filling ratio of about 0.8 is reached, at which point the gap/mid-gap ratio decreases rapidly.

Figure 2B is a plot adapted from the article by Ho et al. (Figure 3(b) therein) that plots the gap/mid-gap ratio as a function of the refractive index contrast (ratio) between air spheres and the refractive index of the substrate. The air spheres are arranged in a diamond crystal structure with a filling ratio of 81%. For this filling ratio, the refractive index of the substrate needs to be greater than about 2. Further, the larger the refractive index ratio, the larger the gap/mid-gap ratio.

Figure 3A is an isometric view of a photonic crystal 304 made up of an array of diamond unit cells 310 formed in substrate 324. The detailed structure of diamond unit cell 310 is illustrated in Figures 3B and 3C. Each diamond unit cell (lattice) 310 is made up of spherical voids 320 formed in a substrate 324, and has a lattice constant $a_0$. Voids 320 may be any shape. However, spherical voids are considered herein as an example for the sake of discussion. Spherical voids 320 are connected by imaginary tetrahedral "bonds" 330. It is assumed below for the sake of illustration that substrate 324 is silicon (optical index, n = 3.6), with the x and y axes in the plane of the substrate and the z-axis normal to the substrate plane. It is further assumed, as an example embodiment, that spherical voids 320 are formed by surface transformation. Thus, photonic crystal 304 is made up of a periodic array of voids 320 as defined by unit cells 310. The periodic array so formed has an incomplete bandgap.

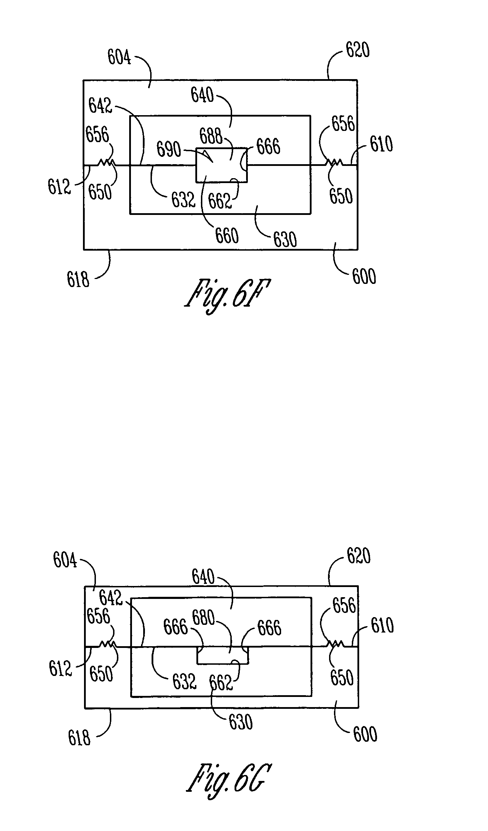

As illustrated in Figure 4, surface transformation involves drilling into substrate 424 a defined set of cylindrical holes 436 having a specific radius R, depth L and separation S (e.g., equal to lattice constant $a_0$), and then annealing the substrate. It will be understood that the method described below can be applied to forming complete photonic bandgaps in other high index (n> 2) substrates such as GaAs, InP, etc., by modifying the annealing conditions.

For simplicity, the formation of one unit cell in (x,y) and N unit cells in the Z-direction is described. To form additional unit cells in the (x,y) plane, repeated translation of the hole pattern, modulo $a_0$, in the x and y directions is all that is required.

To create spherical voids with a lattice periodicity $a_0$ in the z-direction into the substrate requires that the radius of the cylindrical holes must be:

$$R = a_0/8.89 \sim 0.11 \; a_0.$$

After surface transformation, the radius $R_S$ of each spherical void 20 is:

$$R_S = (1.88/8.99)a_0 \sim 0.212 \; a_0$$

The depth L of the initial cylindrical holes required to form by surface transformation each unit cell and the spherical void lattice sites at (x,y,z) for the N unit cells in the z-direction are:

(a) For unit cell sites (1,0,1) and (0,1,1):

$$L_1 = (N) \; a_0 = (N) \; 8.89 \; R$$

(b) For (3/4,1/4,3/4) and (1/4,3/4,3/4):

$$L_{3/4} = (N+1/4) \; a_0$$

(c) For (1/2,0,1/2), (0,1/2,1/2), (1,1/2,1/2) and (1/2,1,1/2)

$$L_{1/2} = (N+1/2) \; a_0$$

The two lattice points (1, 1/2, 1/2) and (1/2, 1, 1/2) are actually in the next adjacent x-translated and y-translated unit cells, respectively. They are given to be consistent with Figures 3A-3C, but are omitted when translating the unit cell in the x and y direction modulo $a_0$.

(d) For (1/4,1/4,1/4) and (3/4,3/4,1/4):

$$L_{1/4} = (N+3/4) \, a_0$$

(e) For (0,0,0), (1/2,1/2,0) and (1,1,0):

$$L_0 = (N+1) \, a_0$$

During annealing (e.g., at 1100° C in a 10 torr atmosphere of hydrogen), spherical voids 320 form in silicon substrate 324 at each of the lattice sites in the vertically stacked N unit cells of diamond lattice 310, as depicted in Figure 3A.

Since the nearest neighbors in diamond lattice 310 are 0.433 $a_0$ distant along the directions of tetrahedral bonds 330 and the spherical void radius $R_S$ is 0.21 $a_0$, the surface transformation formed diamond lattice has a filling ratio of only 0.32.

With reference again to the plot of Figure 2, it can be seen that the filling ratio of 0.32 is not sufficient to produce a complete bandgap (i.e., at a filling ratio of 0.32, the gap size is zero). However, if the fill ratio can be increased to about 0.35 or greater, then a complete bandgap can be achieved.

Figure 5A is an isometric view of a complete bandgap photonic crystal 504 made up of unit cells 510 formed in substrate 514. With reference to Figures 5B and 5C, each unit cell 510 includes spherical voids 520 connected by tetrahedral bonds 530 that form a diamond unit cell identical to unit cell 310 of FIG. 3B. However, unit cell 510 is further modified to include additional spherical voids 540 of radius 0.212$a_0$ at a point halfway along each tetrahedral bond 530. Spherical voids 540 do not alter the diamond symmetry, yet they increase the filling ratio to 0.48, resulting in a complete bandgap with a gap/mid-gap ratio of about 0.1. The unit cell 510 shown in detail Figures 5B and 5C is referred to herein as a "modified diamond unit cell" or a "modified diamond crystal."

The depth L of the initial cylindrical hole required to form by surface transformation spherical voids 520 and 540 at each unit cell lattice location at (x,y,z) for the N modified unit cells in the z-direction are:

(A) For lattice sites (1,0,1) and (0,1,1)

$$L_1 = (N) \, a_0$$

(B) For (7/8,1/8,7/8), (5/8,3/8,7/8), (3/8,5/8,7/8) and (1/8,7/8,7/8)

$$L_{7/8} = (N+1/8) \, a_0$$

(C) For (3/4, 1/4, 3/4) and (1/4,3/4,3/4)

$$L_{3/4} = (N+1/4) \, a_0$$

(D) For (5/8,1/8,5/8), (7/8,3/8,5/8), (1/8,5/8,5/8) and (3/8,7/8,5/8)

$$L_{5/8} = (N+3/8) \, a_0$$

(E) For (1/2,0,1/2), (0,1/2,1/2), (1,1/2,1/2), and (1/2,1,1/2)

$$L_{1/2} = (N+1/2) \, a_0$$

As before, lattice sites (1,1/2,1/2) and (1/2,1,1/2) are actually in the next unit adjacent x-translated and y-translated unit cells respectively. They are given to be consistent with Figures 5A-5C but need to be omitted when translating the unit cell in the x and y direction modulo $a_0$.

(F) For (3/8,1/8,3/8), (1/8,3/8,3/8), (7/8,5/8,3/8) and (5/8,7/8,3/8)

$$L_{3/8} = (N+5/8) \, a_0$$

(G) For (1/4,1/4,1/4), and (3/4,3/4,1/4)

$$L_{1/4} = (N+3/4) \, a_0$$

(H) For (1/8,1/8,1/8), (3/8,3/8,1/8), (5/8,5/8,1/8) and (7/8,7/8,1/8)

$$L_{1/8} = (N+7/8) \, a_0$$

(I) For (0,0,0),(1/2,1/2,0) and (1,1,0)

$$L_0 = (N+1) \, a_0$$

Annealing (e.g., at 1100° C and in a 10 torr hydrogen atmosphere) substrate 524 with the above-defined pattern of cylindrical holes produces spherical voids 520 at the apexes of the tetrahedral bonds 530 and spherical voids 540 halfway between spherical voids 520 along the tetrahedral bonds 530 in the vertically stacked N unit cells of the modified diamond lattice, as depicted in Figures 5A-5C.

The annealing time required to form N (z-stacked) unit cells can be estimated using, for example, the approach described in the paper by Matsutake and Ushiku, presented in the Extended Abstracts of the "2000 International Conference on Solid State Devices and Materials," Tokyo, Japan, pp. 198-199 (2000). For $a_0 \sim 1$ micron and hence $R \sim 0.1$ micron, the annealing time (in seconds) for formation of N (z-stacked) unit cells is estimated to be $\sim N \times 40$.

Although the formation of a complete bandgap 3D crystal lattice from incomplete bandgap crystal lattice has been described in connection with modifying a diamond lattice of spherical voids formed in a silicon substrate, the method applies generally to modifying any incomplete bandgap crystal lattice. The method described in article by Ho et al. can be employed to determine whether a particular crystal structure will have a complete bandgap and if not, if the crystal structure can be modified to produce a complete bandgap. Alternatively, whether a particular crystal structure will yield a complete bandgap, or whether a particular crystal structure can be modified to achieve a complete bandgap can be determined empirically.

**3D photonic crystal waveguide formation**

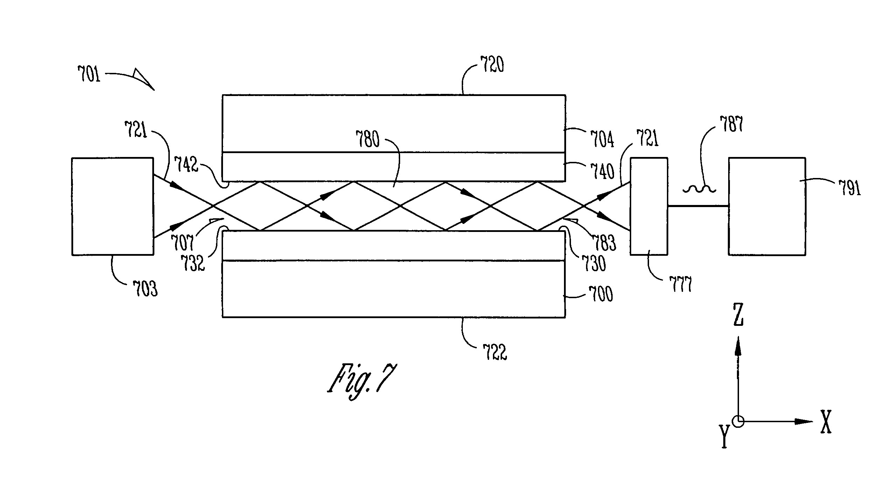

Methods of forming a fully confined 3D photonic bandgap waveguide structure are now described with reference to Figures 6A through 6G.

In Figure 6A, first and second substrates 600 and 604 with respective top surfaces 610 and 612 and respective bottom surfaces 618 and 620 are provided. A first 3D photonic crystal region 630 with an upper surface 632 and a complete bandgap is formed in first substrate 600 to a depth of at least 10 to 15 lattice constants $a_0$ and a width of at least 20 to 30 lattice constants. A second 3D photonic crystal region 640 with an upper surface 642 and a complete bandgap is formed in second substrate 604 Second 3D photonic crystal region 640 is preferably identical (or substantially identical, to within about $0.1\ a_0$) to first 3D photonic crystal region 630.

In an example embodiment, first and second 3D photonic crystal regions 630 and 640 are formed by surface transformation. Further in an example embodiment, first and second 3D photonic crystal regions are formed to have modified crystal structures with complete bandgaps, as discussed above in connection with the example of a modified diamond crystal structure. Generally, first and second 3D photonic crystal regions can have any arrangement of voids that provides a complete bandgap.

In an example embodiment, top surface 610 of substrate 600 includes alignment marks 650 adjacent first 3D photonic crystal region 630, and top surface 612 of substrate 604 includes alignment marks 656 adjacent second 3D photonic crystal region 640. Alignment marks 650 and 656 are designed to facilitate the mutual alignment of 3D photonic crystal regions 630 and 640, as described below.

In Figure 6B, a channel 660 is formed in upper surface 632 of 3D photonic crystal region 630 by removing a number (e.g., 1 to 4) unit cells in the horizontal (Y-direction) and a number (e.g., 1 to 4) unit cells in the vertical (Z-direction). The precise number of unit cells removed depends on the lattice constant and the wavelength of light to be guided. Generally speaking, channel 660 is sized to transmit light of a wavelength corresponding to the complete bandgap of the 3D photonic crystal regions 630 and 640. Any one of a number of standard lithographic techniques, such as etching, can be used to form channel 660. Channel 660 includes a lower wall 662 and opposing sidewalls 666. In an example embodiment, channel 660 has a rectangular cross-section, as shown. In another example embodiment illustrated in Figure 6C, channel 660 includes a bend 670. Though channel 660 is shown to be rectangular in cross-section, other shapes, including a tapered channel 672 as shown in Figure 6D, can be formed.

In Figure 6E, substrates 600 and 604 are placed so that their top surfaces 610 and 612 are confronting. 3D photonic crystal regions 630 and 640 are then aligned with one another (e.g., through the use of alignment marks 650 and 656) and top surfaces 610 and 612 are brought into contact and bonded together using standard substrate bonding techniques. The bonded structure creates, in effect, a single 3D photonic crystal with a 3D channel waveguide 680 defined by lower wall 662, opposing sidewalls 666 of channel 660, and the portion of upper surface 642 of second 3D photonic crystal region 640 covering the channel.

In Figure 6F, an alternative example embodiment is illustrated wherein a rectangular channel 688 having the same width as channel 660 is formed in region 640, so that a channel waveguide 690 is formed from the channels in each of 3D photonic crystal regions 630 and 640.

In Figure 6G, bottom surface 620 of substrate 604 and/or bottom surface 618 of substrate 600 is/are optionally polished down close to 3D photonic crystal region 640 and/or 3D photonic crystal region 630. In some cases, it might be desirable to polish to the top of one or both of 3D photonic crystal regions 640 and 630, or even into one or both of the 3D photonic crystal regions down to near waveguide 680.

**3D photonic crystal waveguide optical system**

3D photonic crystal waveguide optical system 701 can be formed using the 3D photonic crystal waveguide described immediately above and shown, for example, in Figures 6E and 6G.

With reference to Figure 7, waveguide optical system, 701 includes a radiation source 703 operatively coupled to an input end 707 of 3D photonic waveguide 780 so that radiation 721 emitted from the radiation source is transmitted down the waveguide. Radiation 721 has a wavelength within the photonic bandgap of 3D photonic crystal regions 730 and 740 that define waveguide 780. In an example embodiment, radiation source 703 is a laser, such as a diode laser or vertical cavity surface emitting laser (VCSEL),

Radiation 721 is confined in 3D over the entire range of possible propagation angles due to the omnidirectional reflection by each complete bandgap crystal surface e.g., lower channel wall 732, the channel sidewalls (not shown; see 666, FIG. 6G), and upper surface 742 defining waveguide 780. Because waveguide 780 may contain either air, another gas (e.g., nitrogen) or a vacuum, the waveguide is expected to have a transmission, loss comparable to or better than today's low loss fibers (0.3 dB per kilometer) used for long-distance optical communication. Also, bending losses from bends (e.g., bend 670, FIG. 6C) should be remarkably low as compared to conventional waveguides because the reflection mechanism of complete bandgap photonic crystals is not sensitive to incident angle. This allows for waveguide 780 to have bends of up to 90 degrees, providing more design latitude in fabricating waveguide-based integrated optical systems such as couplers, Y-junctions, add-drop multiplexers, and the like.

With continuing reference to Figure 7, a photodetector 777 is operatively coupled to an output end 783 of waveguide 780 to receive and detect radiation 721 having traveled down the waveguide, and to generate an electrical signal (i.e., a photocurrent) 787 in response thereto. Connected to photodetector 777 is an electronic system 791 operable to receive and process electrical signal 787,

There has been described a 3D photonic crystal waveguide structure and methods of forming same. The 3D photonic crystal comprises a periodic array of voids, which in an example embodiment, are formed using the surface transformation technique. Further, in forming the waveguide structure, two 3D photonic crystal regions are interfaced and bonded to form a single 3D photonic crystal. This allows for the waveguide structure to be readily fabricated by forming a channel in at least one of the 3D photonic crystal regions.

The methods described above also allow for a wide variety of different 3D photonic crystal waveguides to be formed, with complete bandgaps at wavelengths ranging from the very small (e.g., ultraviolet and below) to the relatively large (infrared and above). Further, a 3D photonic crystal structure may be modified to have a complete bandgap to form the 3D waveguide structure.

While the present invention has been described in connection with preferred embodiments, it will be understood that it is not so limited. On the contrary, it is intended to cover all alternatives, modifications and equivalents as may be included within the scope of the invention as defined in the appended claims.

## Claims

1. A method of forming a three-dimensional photonic crystal waveguide structure, comprising:

   forming a first three-dimensional photonic crystal region (630) having a complete photonic bandgap;
   forming a second three-dimensional photonic crystal region (640) having the complete photonic bandgap, wherein the first and second three-dimensional photonic crystal regions (630, 640) are substantially identical;
   forming a channel (660, 688) in the first and/or second three-dimensional photonic crystal region (630, 640); and
   interfacing the first and second three-dimensional photonic crystal regions (630, 640) to form a single three-dimensional photonic crystal region so that said channel (660, 688) forms a three-dimensional waveguide (680, 690) surrounded by the first and second three-dimensional photonic crystal regions (630, 640) and sized to receive and guide radiation of a wavelength corresponding to the complete photonic bandgap.

2. The method of claim 1, wherein forming the first three-dimensional photonic crystal region (630) includes:

   forming in a first substrate (600) a first periodic array of unit cells having first voids with an incomplete photonic bandgap, the first voids being connected by imaginary bonds; and
   forming a second periodic array of second voids, wherein each of the second voids is arranged along one of the imaginary bonds to form the first three-dimensional photonic crystal region with the complete photonic bandgap.

3. The method of claim 2, wherein a single one of the second voids is formed halfway between two of the first voids.

4. The method of claim 3, further including:

   determining a filling ratio of voids needed to form the first three-dimensional photonic crystal region with the complete photonic bandgap.

**5.** The method of claim 4, wherein the first substrate (600) includes a material selected from the group of materials consisting of a linear optical material, a non-linear optical material, a metal, a semiconductor, an insulator, a dielectric, an acoustic material, a magnetic material, a ferroelectric material, a piezoelectric material, and a superconducting material.

**6.** The method of claim 2, wherein forming the second three-dimensional photonic crystal region (640) includes:

forming in a second substrate (604) a first periodic array of unit cells formed from first voids with an incomplete photonic bandgap, the first voids being connected by imaginary bonds; and forming a second periodic array of second voids, wherein each of the second voids is arranged along one of the imaginary bonds to form the second three-dimensional photonic crystal region with the complete photonic bandgap.

**7.** The method of claim 6, wherein the first and second voids of each of the first and second three-dimensional photonic crystal regions (630, 640) are spherical.

**8.** The method of claim 1, wherein the channel (660, 688) has a rectangular cross-section.

**9.** The method of claim 1, wherein the channel (660, 688) includes a bend.

**10.** The method of claim 1, wherein the channel (660, 688) includes a taper.

**11.** The method of any one of claims 2 to 7, wherein said voids are formed by drilling holes to a predefined depth and at a predefined position and annealing.

**Patentansprüche**

**1.** Verfahren zur Ausbildung einer dreidimensionalen photonischen Kristallwellenleiterstruktur, umfassend die folgenden Schritte:

Ausbilden eines ersten dreidimensionalen photonischen Kristallbereichs (630) mit einer vollständigen photonischen Bandlücke; Ausbilden eines zweiten dreidimensionalen photonischen Kristallbereichs (640) mit der vollständigen photonischen Bandlücke, wobei der erste und der zweite dreidimensionale photonische Kristallbereich (630,640) im wesentlichen identisch sind; Ausbilden eines Kanals (660,688) im ersten und/oder zweiten dreidimensionalen photonischen Kristallbereich (630,640); und Verbinden des ersten und des zweiten dreidimensionalen photonischen Kristallbereichs (630,640), damit sie einen einzigen dreidimensionalen photonischen Kristallbereich bilden, so daß der Kanal (660,688) einen dreidimensionalen Wellenleiter (680,690) bildet, der vom ersten und zweiten dreidimensionalen photonischen Kristallbereich (630,640) umgeben und dafür bemessen ist, Strahlung mit einer Wellenlänge, die der vollständigen photonischen Bandlücke entspricht, zu empfangen und zu leiten.

**2.** Verfahren nach Anspruch 1, wobei der Schritt des Ausbildens des ersten dreidimensionalen photonischen Kristallbereichs (630) die folgenden Schritte aufweist:

in einem ersten Substrat (600) erfolgendes Ausbilden einer ersten periodischen Anordnung von Einheitszellen mit ersten Leerstellen mit einer unvollständigen photonischen Bandlücke, wobei die ersten Leerstellen durch imaginäre Bindungen verbunden sind; und Ausbilden einer zweiten periodischen Anordnung von zweiten Leerstellen, wobei jede der zweiten Leerstellen entlang einer der imaginären Bindungen angeordnet ist, um den ersten dreidimensionalen photonischen Kristallbereich mit der vollständigen photonischen Bandlücke auszubilden.

**3.** Verfahren nach Anspruch 2, wobei eine einzelne der beiden Leerstellen in der Mitte zwischen zwei der ersten Leerstellen ausgebildet wird.

**4.** Verfahren nach Anspruch 3, ferner mit dem folgenden Schritt:

Bestimmen eines Füllungsverhältnisses der Leerstellen, das nötig ist, um den ersten dreidimensionalen photonischen Kristallbereich mit der vollständigen photonischen Bandlücke auszubilden.

**5.** Verfahren nach Anspruch 4, wobei das erste Substrat (600) ein Material aufweist, das aus der Gruppe von Materialien ausgewählt ist, die aus den folgenden besteht: ein lineares optisches Material, ein nichtlineares optisches Material, ein Metall, ein Halbleiter, ein Isolator, ein Dielektrikum, ein akustisches Material, ein magnetisches Material, ein ferroelektrisches Material, ein piezoelektrisches Material und ein supraleitendes Material.

**6.** Verfahren nach Anspruch 2, wobei der Schritt des Ausbildens des zweiten dreidimensionalen photonischen Kristallbereichs (640) die folgenden Schritte aufweist:

in einem zweiten Substrat (604) erfolgendes Ausbilden einer ersten periodischen Anordnung von Einheitszellen, die aus ersten Leerstellen mit einer unvollständigen photonischen Bandlücke gebildet werden, wobei die ersten Leerstellen durch imaginäre Bindungen verbunden sind; und

Ausbilden einer zweiten periodischen Anordnung von zweiten Leerstellen, wobei jede der zweiten Leerstellen entlang einer der imaginären Bindungen angeordnet ist, um den zweiten dreidimensionalen photonischen Kristallbereich mit der vollständigen photonischen Bandlücke auszubilden.

7. Verfahren nach Anspruch 6, wobei die ersten und zweiten Leerstellen sowohl des ersten als auch des zweiten dreidimensionalen photonischen Kristallbereichs (630,640) sphärisch sind.

8. Verfahren nach Anspruch 1, wobei der Kanal (660,688) einen rechteckigen Querschnitt hat.

9. Verfahren nach Anspruch 1, wobei der Kanal (660,688) eine Biegung aufweist.

10. Verfahren nach Anspruch 1, wobei der Kanal (660,688) eine Verjüngung aufweist.

11. Verfahren nach einem der Ansprüche 2 bis 7, wobei die Leerstellen durch Bohren von Löchern bis zu einer vorbestimmten Tiefe und an einer vordefinierten Position und durch Tempern ausgebildet werden.


**Revendications**

1. Procédé de formation d'une structure de guide d'ondes tridimensionnelle à cristaux photoniques, comprenant:

la formation d'une première région tridimensionnelle de cristaux photoniques (630) présentant une bande interdite photonique complète;
la formation d'une seconde région tridimensionnelle de cristaux photoniques (640) présentant la bande interdite photonique complète, dans laquelle les première et seconde régions tridimensionnelles de cristaux photoniques (630, 640) sont sensiblement identiques;
la formation d'un canal (660, 688) dans les première et/ou seconde régions tridimensionnelles de cristaux photoniques (630, 640); et
l'interfaçage des première et seconde régions tridimensionnelles de cristaux photoniques (630, 640) afin de former une unique région tridimensionnelle de cristaux photoniques de telle sorte que ledit canal (660, 688) forme un guide d'ondes tridimensionnel (680, 690) entouré par les première et seconde régions tridimensionnelles de cristaux photoniques (630, 640) et dimensionné pour recevoir et guider un rayonnement d'une longueur d'onde correspondant à la bande interdite photonique complète.

2. Procédé selon la revendication 1, dans lequel la formation de la première région tridimensionnelle de cristaux photoniques (630) inclut:

la formation dans un premier substrat (600) d'un premier réseau périodique de cellules unitaires comportant des premiers vides avec une bande interdite photonique incomplète, les premiers vides étant connectés par des liaisons imaginaires; et
la formation d'un second réseau périodique de seconds vides, dans lequel chacun des seconds vides est agencé suivant l'une des liaisons imaginaires de manière à former la première région tridimensionnelle de cristaux photoniques avec la bande interdite photonique complète.

3. Procédé selon la revendication 2, dans lequel un unique des seconds vides est formé à mi-chemin entre deux des premiers vides.

4. Procédé selon la revendication 3, incluant en outre:

la détermination d'un taux de remplissage de vides nécessaire pour former la première région tridimensionnelle de cristaux photoniques avec la bande interdite photonique complète.

5. Procédé selon la revendication 4, dans lequel le premier substrat (600) inclut un matériau choisi parmi le groupe de matériaux constitué par un matériau optique linéaire, un matériau optique non linéaire, un métal, un semiconducteur, un isolant, un diélectrique, un matériau acoustique, un matériau magnétique, un matériau ferroélectrique, un matériau piézoélectrique et un matériau supraconducteur.

6. Procédé selon la revendication 2, dans lequel la formation de la seconde région tridimensionnelle de cristaux photoniques (640) inclut:

la formation dans un second substrat (604) d'un premier réseau périodique de cellules unitaires formé à partir de premiers vides avec une bande interdite photonique incomplète, les premiers vides étant connectés par des liaisons imaginaires; et
la formation d'un second réseau périodique de seconds vides, dans lequel chacun des seconds vides est agencé suivant l'une des liaisons imaginaires de manière à former la seconde région tridimensionnelle de cristaux photoniques avec la bande interdite photonique complète.

**7.** Procédé selon la revendication 6, dans lequel les premiers et seconds vides de chacune des première et seconde régions tridimensionnelles de cristaux photoniques (630, 640) sont sphériques.

**8.** Procédé selon la revendication 1, dans lequel le canal (660, 688) présente une section en coupe rectangulaire.

**9.** Procédé selon la revendication 1, dans lequel le canal (660, 688) inclut une partie courbe.

**10.** Procédé selon la revendication 1, dans lequel le canal (660, 688) inclut une partie à bords inclinés.

**11.** Procédé selon l'une quelconque des revendications 2 à 7, dans lequel lesdits vides sont formés en perçant des trous jusqu'à une profondeur prédéfinie et en une position prédéfinie et en effectuant un recuit.

CUBIC P          CUBIC I          CUBIC F

TETRAGONAL P          TETRAGONAL I

ORTHORHOMBIC P     ORTHORHOMBIC C     ORTHORHOMBIC I     ORTHORHOMBIC F

MONOCLINIC P          MONOCLINIC C          TRICLINIC

TRIGONAL R          TRIGONAL AND HEXAGONAL P

*Fig. 1*

*Fig.2A*

*Fig.2B*

304

324

310

310

3B-3B

*Fig. 3A*

310

320

330

320

330

$a_0$

$a_0$

320

330

320

$a_0$

Z

Y

X

*Fig. 3B*

Fig.3C

*Fig. 4*

Fig.5A

Fig.5B

Fig.5C

*Fig.6A*

*Fig.6B*

*Fig.6C*

632

600

672

630

600

*Fig. 6D*

604

620

642

640

656

656

610

666 680

666

612

650

632 662

650

618

600

630

Z

X

Y

*Fig. 6E*

*Fig. 6F*

*Fig. 6G*

Fig.7

EP 1 466 199 B1